# EUROPEAN PATENT SPECIFICATION

(11) **EP 4 607 497 B1**
(45) Date of publication and mention of the grant of the patent: **09.12.2026**
(21) Application number: 25179909.4
(22) Date of filing: 15.09.2017
(51) Int. Cl.: G09G 3/3208

(54) **OLED EXTERNAL COMPENSATION CIRCUIT OF DEPLETION-TYPE TFT**
EXTERNE OLED-KOMPENSATIONSSCHALTUNG EINES ERSCHÖPFUNGS-TFT
CIRCUIT DE COMPENSATION EXTERNE DE DELO DE TFT DE TYPE À APPAUVRISSEMENT

(30) Priority: 14.08.2017 CN 201710693609
(43) Date of publication of application: 27.08.2025
(62) Document number(s) of the earlier application(s) in accordance with Art. 76 EPC: 17921884.7 / 3 671 709
(73) Proprietor: Shenzhen China Star Optoelectronics Semiconductor Display Technology Co., Ltd., Shenzhen, Guangdong 518132 (CN)
(72) Inventor: SHI, Longqiang, Shenzhen, Guangdong,, 518132 (CN)
(74) Representative: Murgitroyd & Company

(56) References cited:
- US-A1- 2010 201 717
- US-A1- 2016 117 983
- US-A1- 2017 061 876

## Description

The present application is a Divisional Application of EP 17921884.7, which is a European Regional Phase Application of PCT/CN2017/101976, filed on September 15, 2017.

### Technical Field

The present invention relates to the field of liquid crystal display, and more particularly to an OLED external compensation circuit of a depletion type TFT.

### Background

Organic light Emitting Display (OLED) display device with self-luminous, low driving voltage, high luminous efficiency, short response time, sharpness and contrast, nearly 180 ° viewing angle, the use of a wide temperature range, flexible display, large area full color display and many other advantages, the industry is recognized as the most development potential of the display device.

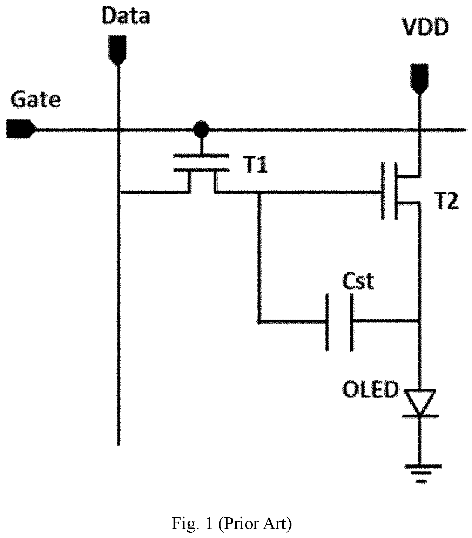

Fig. 1 is an illustrative diagram of a conventional 2T1C OLED driving circuit. The conventional OLED driving circuit is composed of 2T1C, that is, a structure with two thin film transistors (TFT) plus a capacitor, to convert the voltage to the current, T1 is a switch TFT, used to control the entering of the data signal Vdata, T2 is a driving TFT, used to control the current through the OLED, Cst is a storage capacitor. Due to prolonged operation, T2 is under severe voltage stress and the threshold voltage Vth will shift. According to the known formula of current, Ids = β/2 (Vgs-Vth)^2, when Vdata is the same, the change of Vth will inevitably lead to the change of Ids. Because the OLED is a current-driving drive, it inevitably affects the brightness of the OLED, which affects the normal display. In order to solve this problem, one idea is to introduce an internal compensation circuit that counteracts the effect of the Vth shift. But the conventional compensation circuit is more complex, the number of TFT is generally more than 5. So many TFTs will occupy a lot of space, and it will inevitably affect the pixel area of the opening area, which is not beneficial for high aperture and high-resolution display design.

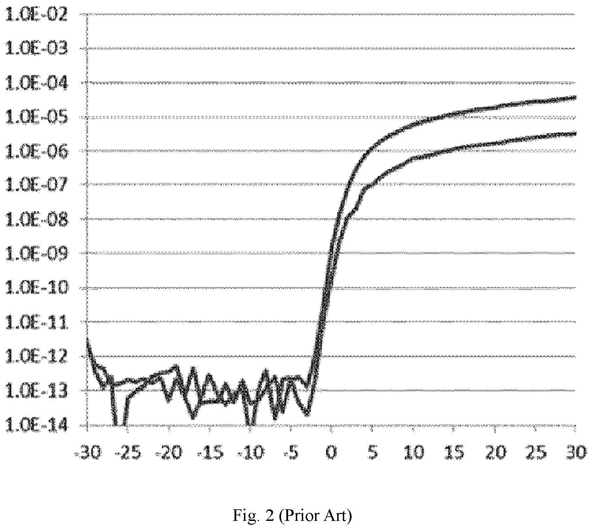

The IGZO (indium gallium zinc oxide)-TFT with BCE (Back-channel-etch) structure is the hotspot of the present research. However, the current performance of the IGZO-TFT is mostly as depletion type TFT, that is, the threshold voltage (Vth) is negative. The transfer characteristic curve of the depleted IGZO-TFT is shown in Fig. 2, where the horizontal axis is the voltage (volts) and the vertical axis is the current (amperes). Due to the characteristics of the depleted IGZO-TFT, the circuit design is more complex.

US2010201717A1 discloses a display device and driving method thereof. US2017061876A1 discloses a pixel and driving methos thereof. US2016117983A1 discloses a pixel circuit, driving method thereof and display panel.

### Summary

The present invention is defined by the independent claim as appended. Developments are set forth in the dependent claim.

Therefore, an object of the present invention to provide an OLED external compensation circuit for a depletion type TFT for the complicated characteristics of the conventional designs of the depletion type TFT and the OLED external compensation.

In order to achieve the object, the present invention provides an OLED external compensation circuit of a depletion type TFT, which comprises a first thin film transistor, a second thin film transistor, a capacitor, an organic light emitting diode, and a compensation circuit. The second thin film transistor is a depletion type. A gate electrode of the first thin film transistor is inputted with a gate line signal. A source electrode and a drain electrode of the first thin film transistor are respectively inputted with a data signal and connected with a first node. A gate of the second thin film transistor is connected with the first node. A source electrode and a drain electrode of the second thin film transistor are respectively inputted with a DC high voltage power supply and connected with a second node. Both ends of the capacitor are connected with at the first node and the second node. A positive electrode of the organic light emitting diode is connected with the second node and the negative electrode of the organic light emitting diode is grounded. The compensation circuit is connected with the first node and the second node. An AC reset signal is inputted to the compensation circuit. The AC reset signal is turned on at a blanking time of each frame when an OLED display device displays an image, and is turned off when normally operated on each frame. When the AC reset signal is turned on, the compensation circuit changes the voltages of the first node and the second node.

Wherein the compensation circuit comprises a third thin film transistor. A gate electrode of the third thin film transistor is inputted with the AC reset signal. A source electrode and a drain electrode of the third thin film transistor are respectively inputted with a DC reference potential and connected with the first node and the second node at the same time.

### During operation:

In the first stage, the AC reset signal is at a high potential at which time the third thin film transistor is turned on and a signal of the DC reference potential is written (e.g., applied) to the first node and the second node.

In the second stage, the gate line signal and the AC reset signal are at a low potential, the first thin film transistor and the third thin film transistor are turned off and the second thin film transistor is still turned on.

In the third stage, when the gate line signal is at a high potential, the first thin film transistor is turned on and the data signal is written to the first node.

The present invention further provides another OLED external compensation circuit of a depletion type TFT, which comprises a first thin film transistor, a second thin film transistor, a capacitor, an organic light emitting diode, and a compensation circuit. The second thin film transistor is a depletion type. A gate electrode of the first thin film transistor is inputted with a gate line signal. A source electrode and a drain electrode of the first thin film transistor are respectively inputted with a data signal and connected with a first node. A gate of the second thin film transistor is connected with the first node. A source electrode and a drain electrode of the second thin film transistor are respectively inputted with a DC high voltage power supply and connected with a second node. Both ends of the capacitor are connected with at the first node and the second node. A positive electrode of the organic light emitting diode is connected with the second node and the negative electrode of the organic light emitting diode is grounded. The compensation circuit is connected with the first node and the second node. An AC reference potential is inputted to the compensation circuit. The AC reference potential is turned on at a blanking time of each frame when an OLED display device displays an image, and is turned off when normally operated on each frame. When the AC reference potential is turned on, the compensation circuit changes the voltages of the first node and the second node.

Wherein the compensation circuit comprises a third thin film transistor and a fourth thin film transistor. A gate electrode of the third thin film transistor is inputted with the AC reference potential. A source electrode and a drain electrode of the third thin film transistor are respectively connected with a drain electrode/ source electrode of the fourth thin film transistor and connected with the first node and the second node at the same time. A gate electrode of the fourth thin film transistor is inputted with the AC reference potential.

### During operation:

In the first stage, the AC reference potential is at a high potential at which time the third thin film transistor and the fourth thin film transistor are turned on and a signal of the AC reference potential is written to the first node and the second node.

In the second stage, the gate line signal and the AC reference potential are at a low potential, the first thin film transistor, the third thin film transistor, and the fourth thin film transistor are turned off and the second thin film transistor is still turned on.

In the third stage, when the gate line signal is at a high potential, the first thin film transistor is turned on and the data signal is written to the first node.

The present invention further provides still another OLED external compensation circuit of a depletion type TFT, which comprises a first thin film transistor, a second thin film transistor, a capacitor, an organic light emitting diode, and a compensation circuit. The second thin film transistor is a depletion type. A gate electrode of the first thin film transistor is inputted with a gate line signal. A source electrode and a drain electrode of the first thin film transistor are respectively inputted with a data signal and connected with a first node. A gate of the second thin film transistor is connected with the first node. A source electrode and a drain electrode of the second thin film transistor are respectively inputted with a DC high voltage power supply and connected with a second node. Both ends of the capacitor are connected with at the first node and the second node. A positive electrode of the organic light emitting diode is connected with the second node and the negative electrode of the organic light emitting diode is grounded. The compensation circuit is connected with the first node and the second node. A first AC reference potential and a second AC reference potential are inputted to the compensation circuit. The first AC reference potential and the second AC reference potential are turned on at a blanking time of each frame when an OLED display device displays an image, and are turned off when normally operated on each frame. When the first AC reference potential and the second AC reference potential are turned on. The compensation circuit changes the voltages of the first node and the second node.

Wherein the compensation circuit comprises a third thin film transistor and a fourth thin film transistor. A gate electrode of the third thin film transistor is inputted with the first AC reference potential. A source electrode and a drain electrode of the third thin film transistor are respectively inputted with the first AC reference potential and connected with the first node. A gate electrode of the fourth thin film transistor is inputted with the first AC reference potential. A source electrode and a drain electrode of the fourth thin film transistor are respectively inputted with the second AC reference potential and connected with the second node.

### During operation:

In the first stage, the first AC reference potential and the second AC reference potential are at a high potential at which time the third thin film transistor and the fourth thin film transistor are turned on, a signal of the first AC reference potential is written to the first node and a signal of the second AC reference potential is written to the second node.

In the second stage, the gate line signal and the first AC reference potential are at a low potential, the first thin film transistor, the third thin film transistor, and the fourth thin film transistor are turned off and the second thin film transistor is still turned on.

In the third stage, when the gate line signal is at a high potential, the first thin film transistor is turned on and the data signal is written to the first node.

Wherein a voltage difference between the first AC reference potential and the second AC reference potential is adjustable.

In summary, the present invention provides an OLED external compensation circuit suitable for a depletion type TFT in view of the complicated characteristics of the conventional designs of the depletion type TFT and the OLED external compensation. The OLED external compensation circuit of another depletion type TFT of the present invention, which reduces the cost of the system chip, thereby achieving cost reduction. The OLED external compensation circuit of another depletion type TFT of the present invention can be compatible with an enhanced TFT (Vth is positive) circuit.

### Brief Description of the Drawings

For better understanding the technical proposals and other beneficial effects of the present invention, please refer the following detailed description of the present invention with the accompanying drawings.

In drawings:
Fig. 1 is an illustrative diagram of an OLED driving circuit of 2T1C according to the conventional art.
Fig. 2 is a transfer characteristic curve of a depletion type IGZO-TFT.
Fig. 3 is a schematic diagram of an OLED external compensation circuit of a first depletion type TFT not falling under the scope of the appended claims and to be considered merely as example suitable for understanding the invention.
Fig. 4 is a waveform diagram of an OLED external compensation circuit of the first depletion type TFT not falling under the scope of the appended claims and to be considered merely as example suitable for understanding the invention.
Fig. 5 is a schematic diagram of an OLED external compensation circuit of a second depletion type TFT not falling under the scope of the appended claims and to be considered merely as example suitable for understanding the invention.
Fig. 6 is a waveform diagram of an OLED external compensation circuit of the second depletion type TFT not falling under the scope of the appended claims and to be considered merely as example suitable for understanding the invention.
Fig. 7 is a schematic diagram of an OLED external compensation circuit of a third depletion type TFT according to the present invention.
Fig. 8 is a waveform diagram of an OLED external compensation circuit of the third depletion type TFT according to the present invention.

### Detailed Description of the Embodiments

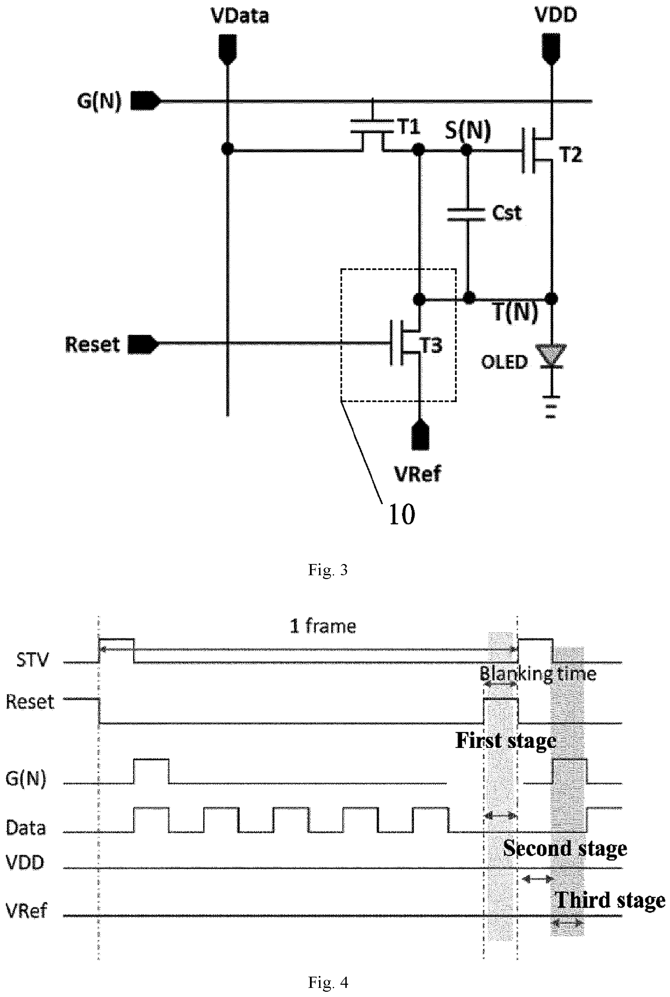

Fig. 3 is a first external compensation circuit not falling under the scope of the appended claims and to be considered merely as example suitable for understanding the invention.

The circuit is composed of three TFTs and one Cst, the main difference with the conventional external compensation circuit is the compensation circuit 10, which comprises a thin film transistor T3. A gate electrode of the thin film transistor is inputted with an AC reset signal Reset. A source electrode and a drain electrode of the thin film transistor are respectively inputted with a DC reference potential Vref and connected with the node S (N) and the node T (N) simultaneously. Vdata is the data signal. G (N) is the signal corresponding to any gate line. The high potential is 28V and the low potential is -7V VDD is a direct current (DC) high voltage power supply; the potential is generally set to be 28V Vref is the reference potential, which is less than the DC high voltage power supply of the VDD, the potential is generally set to 5V The Reset signal Reset is AC, the high potential is 28V and the low potential is -7V.

The depletion TFT of the present invention may be IGZO-TFT.

Fig. 4 is a drawing of the corresponding waveform, which illustrate the correspondence between signals. STV is a trigger signal, and the time from the first STV to the second STV is used to define a frame time, the STV signal of the OLED display device is introduced to help understand the operation of the compensation circuit. The reset signal Reset starts in the blanking time of each frame and closes when each frame normally works. The blanking time refers to the interval between the end of the n-th frame image signal and the start of the (n+1)th frame image signal of the OLED display device.

The working status is described as below:

### The first stage:

Blanking time phase, at this stage, Reset is at the high potential, then T3 is opened, signal of Vref is written (e.g., applied) to S (N) and T (N), potential of sides of the gate electrode and the source electrode of the TFT T2 are rewritten to the potential of Vref, and all the TFTs are homered. At this moment, Vgs=Vg-Vs=V_S(N)-V_T(N)=Vref-Vref=0.

The second stage: Vth extraction phase. At this time, the potential of G (N) and Reset are at low potentials, T1 and T3 are closed. Since it is a depletion type TFT (Vth <0), T2 is still at the open phase. $Vds = VDD - T \left(N\right) .$ Since Vgs = 0 << Vds, T2 is at the saturation phase. So at the final equilibrium stage, Vgs = Vth, and Vs = Vg-Vth = Vref-Vth.

The third stage: Vth compensation phase. When G (N) is on and T1 is on, the signal Vdata of data is written to node S (N). At T2, Vgs = V_S (N) - V_T (N) = Vdata-(Vref - Vth) = Vdata-Vref + Vth.

At this time, the current is independent from Vth according to the saturation current formula Ids = β/2(Vgs-Vth)^2 = β/2(Vdata-Vref+Vth-Vth)^2 = β/2(Vdata-Vref), to get a good compensation.

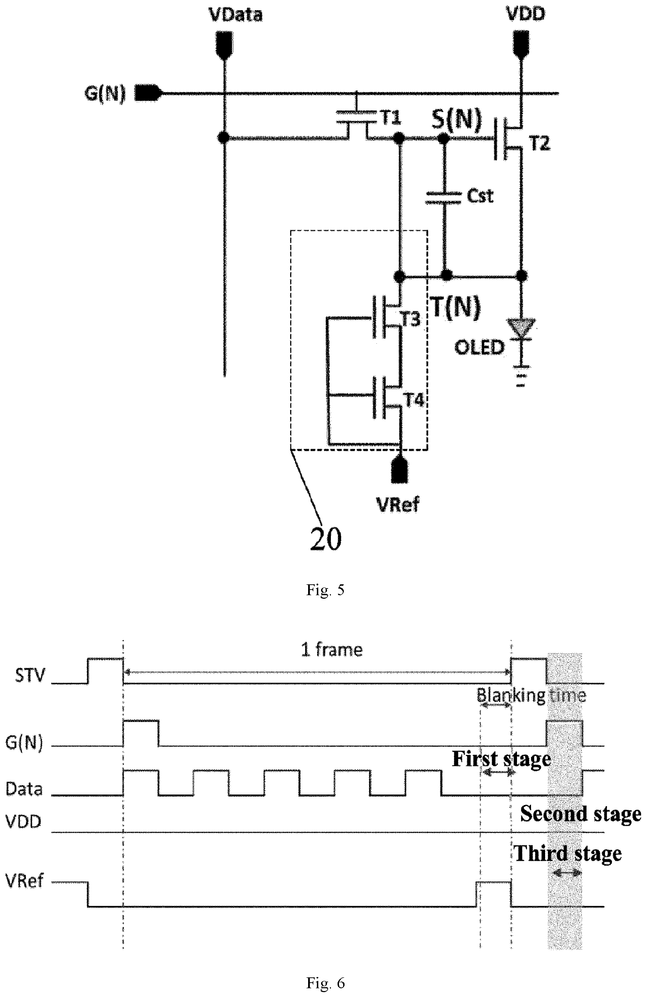

Fig. 5 is a second external compensation circuit not falling under the scope of the appended claims and to be considered merely as example suitable for understanding the invention.

The circuit is composed of four TFTs and one Cst. The compensation circuit 20 includes a thin film transistor T3 and a thin film transistor T4. A gate electrode of T3 is inputted with the AC reference potential Vref, a source electrode and a drain electrode of T3 are connected with a source/drain electrode of the T4, the node S (N) and the node T N) at the same time. A gate electrode of T4 is inputted with the AC reference potential Vref and the other source / drain electrodes of T4 are also inputted with the AC reference potential Vref Vdata is the data signal. G (N) is the signal corresponding to any gate line. The high potential is 28V and the low potential is -7V VDD is a direct current (DC) high voltage power supply, the potential is generally set to be 28V Vref is the reference potential, which is an AC power supply, the high potential is 28V and the low potential is -7V.

Fig. 6 is a drawing of the corresponding waveform, which illustrate the correspondence between signals. STV is a trigger signal, and the time from the first STV to the second STV is used to define a frame time. The Vref starts in the blanking time of each frame and closes when each frame normally works.

Compared with the first external compensation circuit, the second circuit increases with a TFT and increases the space, but eliminates the need for a Reset signal, reducing the cost of the integrated chip (IC), in order to achieve cost reduction.

The working status is described as below:

### The first stage:

Blanking time phase, at this stage, Vref is at the high potential, then T3 and T4 are opened, signal of Vref is written to S (N) and T (N), potential of sides of the gate electrode and the source electrode of the TFT T2 are rewritten to the potential of Vref, and all the TFTs are homered. At this moment, Vgs=Vg-Vs=V_S(N)-V_T(N)=Vref-Vref=0.

The second stage: Vth extraction phase. At this time, the potential of G (N) and Vref are at low potentials, T1, T3, and T4 are closed. Since it is a depletion type TFT (Vth <0), T2 is still at the open phase. $Vds = VDD - T \left(N\right) .$ Since Vgs = 0 << Vds, T2 is at the saturation phase. So at the final equilibrium stage, Vgs = Vth, and Vs = Vg-Vth = Vref-Vth.

The third stage: Vth compensation phase. When G (N) is on and T1 is on, the signal Vdata of data is written to node S (N). At T2, Vgs = V_S (N) - V_T (N) = Vdata-(Vref - Vth) = Vdata-Vref + Vth.

At this time, the current is independent from Vth according to the saturation current formula Ids = β/2(Vgs-Vth)^2 = β/2(Vdata-Vref+Vth-Vth)^2 = β/2(Vdata-Vref), to get a good compensation.

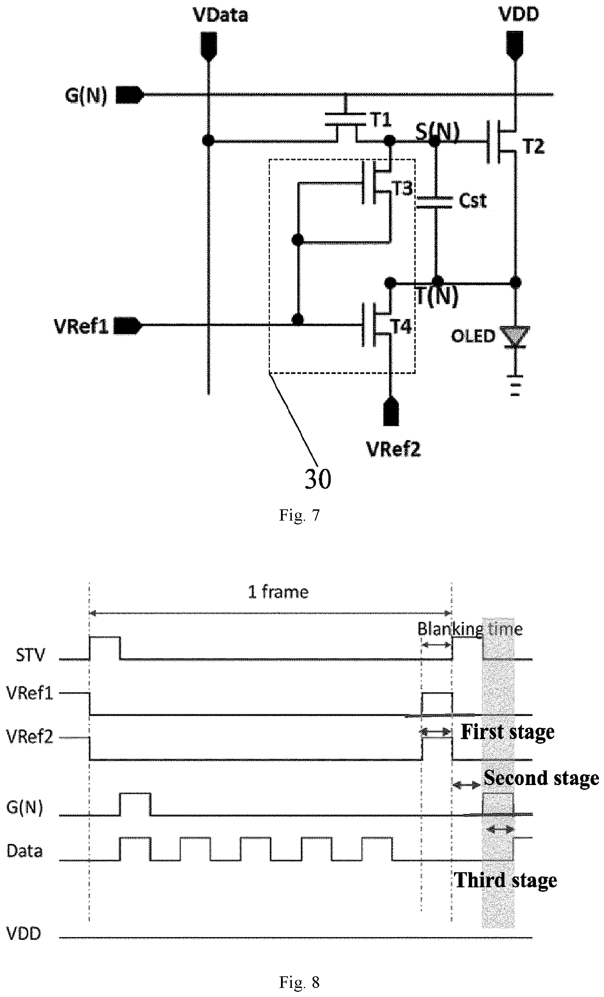

Fig. 7 is a third external compensation circuit according to the present invention. The circuit is composed of four TFTs and one Cst. The compensation circuit 30 includes thin film transistors T3, T4. A gate electrode of T3 is inputted with the AC reference potential Vrefl, a source electrode and a drain electrode of T3 are respectively inputted with the AC reference potential Vref and connected with the node S (N). A gate electrode of T4 is inputted with the AC reference potential Vrefl. A source electrode and a drain electrode of T4 are respectively also inputted with the AC reference potential Vref2 and connected with the node T(N). Vdata is the data signal. G (N) is the signal corresponding to any gate line. The high potential is 28V and the low potential is -7V VDD is a direct current (DC) high voltage power supply; the potential is generally set to be 28V Vrefl and Vref2 are both the reference potential, which is an AC power supply, the high potential is 28V and the low potential is -7V The voltage difference between Vrefl and Vref2 is adjustable.

Fig. 8 is a drawing of the corresponding waveform, which illustrate the correspondence between signals. STV is a trigger signal, and the time from the first STV to the second STV is used to define a frame time. The Vref starts in the blanking time of each frame and closes when each frame normally works.

Compared with the previous two circuits, it is characterized that the voltage difference between Vrefl and Vref2 is adjustable. The circuit can be compatible with enhanced TFT (Vth is positive) circuit.

The working status is described as below:

### The first stage:

Blanking time phase, at this stage, Vrefl and Vref2 are at the high potential, then T3 and T4 are opened, signal of Vrefl is written to T (N), in other words, potential of sides of the gate electrode and the source electrode of the TFT T2 are respectively rewritten to the potentials of Vrefl and Verf2, and all the TFTs are homered. At this moment, Vgs=Vg-Vs=V_S(N)-V_T(N)=Vref1 -Vref2=0.

If the TFT is depletion type, Vth<0, Vgs=Vref1-Vref2 can be set to be less than or equal to 0 and greater than Vth.

If the TFT is enhancement type, Vth>0, Vgs=Vrefl-Vref2 can be set to be greater than or equal to 0 and greater than Vth.

The second stage: Vth extraction phase. At this time, the potential of G (N) and Vrefl are at low potentials, T1, T3, and T4 are closed. For the setting of Vrefl and Vref2 is ensured that Vgs=Vrefl-Vref1>=Vth, T2 is still at the open phase. $Vds = VDD - T \left(N\right) .$ Since Vgs = Vrefl-Vref2>= Vth, T2 is at the saturation phase. So at the final equilibrium stage, Vgs = Vth, and Vs = Vg-Vth = Vrefl-Vth.

The third stage: Vth compensation phase. When G (N) is on and T1 is on, the signal Vdata of data is written to node S (N). At T2, Vgs = V_S (N) - V_T (N) = Vdata-(Vrefl - Vth) = Vdata-Vrefl + Vth.

At this time, the current is independent from Vth according to the saturation current formula Ids = β/2(Vgs-Vth)^2 = β/2(Vdata-Vrefl+Vth-Vth)^2 = β/2(Vdata-Vref1), to get a good compensation.

In summary, the present invention provides an OLED external compensation circuit suitable for a depletion type TFT in view of the complicated characteristics of the conventional designs of the depletion type TFT and the OLED external compensation. The OLED external compensation circuit of another depletion type TFT of the present invention, which reduces the cost of the system chip, thereby achieving cost reduction. The OLED external compensation circuit of another depletion type TFT of the present invention can be compatible with an enhanced TFT (Vth is positive) circuit.

## Claims

1. An OLED external compensation circuit of a depletion type TFT, comprising a first thin film transistor (T1), a second thin film transistor (T2), a capacitor (Cst), an organic light emitting diode (OLED), and a compensation circuit (30); the second thin film transistor (T2) being a depletion type; means configured to input a gate line signal (G(N)) to a gate electrode of the first thin film transistor (T1);
means configured to input a data signal (VData) to a source electrode of the first thin film transistor (T1; a drain electrode of the first thin film transistor (T1) being connected with a first node (S(N)); a gate of the second thin film transistor (T2) being connected with the first node (S(N)); means configured to input a DC high voltage power supply (VDD) to a source electrode of the second thin film transistor (T2); a drain electrode of the second thin film transistor (T2) being connected with a second node (T(N)); one end of the capacitor (Cst) being connected with the first node (S(N)) and the other end of the capacitor (Cst) being connected with the second node (T(N)); a positive electrode of the organic light emitting diode (OLED) being connected with the second node and a negative electrode of the organic light emitting diode (OLED) being grounded; the compensation circuit (30) being connected with the first node (S(N)) and the second node (T(N)); means configured to input a first AC reference potential (VRef1) and a second AC reference potential (VRef2) to the compensation circuit (30);
**characterized in that** the voltage difference between the first AC reference potential (VRef1) and the second AC reference potential (VRef2) is adjustable, wherein
the compensation circuit (30) comprises a third thin film transistor (T3) and a fourth thin film transistor (T4); a gate electrode of the third thin film transistor (T3) is inputted with the first AC reference potential (VRef1); a source electrode and a drain electrode of the third thin film transistor (T3) are respectively inputted with the first AC reference potential (VRef1) and connected with the first node (S(N)); a gate electrode of the fourth thin film transistor (T4) is inputted with the first AC reference potential (VRef1); a source electrode and a drain electrode of the fourth thin film transistor (T4) are respectively inputted with the second AC reference potential (VRef2) and connected with the second node (T(N)), and wherein during a blanking time period of a frame period the first AC reference potential (VRef1) and the second AC reference potential (VRef2) are at a high potential for turning on the third thin film transistor (T3) and the fourth thin film transistor (T4), respectively, and the gate line signal and the data signal are at a low potential, and the first AC reference potential (VRef1) and the second AC reference potential (VRef2) are at a low potential for turning off the third thin film transistor (T3) and the fourth thin film transistor (T4) during the rest of the frame period.

2. The OLED external compensation circuit of a depletion type TFT according to claim 1, **characterized in that** the DC high voltage power supply (VDD) has a potential of 28V, and the high potential is 28V and the low potential is -7V.

## Patentansprüche

1. Externe Kompensationsschaltung für eine OLED mit einem TFT vom Verarmungstyp, umfassend einen ersten Dünnschichttransistor (T1), einen zweiten Dünnschichttransistor (T2), einen Kondensator (Cst), eine organische Leuchtdiode (OLED) und eine Kompensationsschaltung (30); wobei der zweite Dünnschichttransistor (T2) vom Verarmungstyp ist; eine Einrichtung, die so konfiguriert ist, dass sie ein Gate-Leitungssignal (G(N)) an eine Gate-Elektrode des ersten Dünnschichttransistors (T1) anlegt; eine Einrichtung, die so konfiguriert ist, dass sie ein Datensignal (VData) an eine Source-Elektrode des ersten Dünnschichttransistors (T1) anlegt;
wobei eine Drain-Elektrode des ersten Dünnschichttransistors (T1) mit einem ersten Knoten (S(N)) verbunden ist; wobei ein Gate des zweiten Dünnschichttransistors (T2) mit dem ersten Knoten (S(N)) verbunden ist; eine Einrichtung, die so konfiguriert ist, dass sie eine Gleichstrom-Hochspannungsversorgung (VDD) an eine Source-Elektrode des zweiten Dünnschichttransistors (T2) anlegt; wobei eine Drain-Elektrode des zweiten Dünnschichttransistors (T2) mit einem zweiten Knoten (T(N)) verbunden ist; wobei ein Ende des Kondensators (Cst) mit dem ersten Knoten (S(N)) verbunden ist und das andere Ende des Kondensators (Cst) mit dem zweiten Knoten (T(N)) verbunden ist; wobei eine positive Elektrode der organischen Leuchtdiode (OLED) mit dem zweiten Knoten verbunden ist und eine negative Elektrode der organischen Leuchtdiode (OLED) geerdet ist; wobei die Kompensationsschaltung (30) mit dem ersten Knoten (S(N)) und dem zweiten Knoten (T(N)) verbunden ist; Mittel, die so konfiguriert sind, dass sie ein erstes Wechselstrom-Referenzpotential (VRef1) und ein zweites Wechselstrom-Referenzpotential (VRef2) in die Kompensationsschaltung (30) einspeisen;
**dadurch gekennzeichnet, dass** die Spannungsdifferenz zwischen dem ersten Wechselstrom-Referenzpotential (VRef1) und dem zweiten Wechselstrom-Referenzpotential (VRef2) einstellbar ist, wobei die Kompensationsschaltung (30) einen dritten Dünnschichttransistor (T3) und einen vierten Dünnschichttransistor (T4) umfasst; einer Gate-Elektrode des dritten Dünnschichttransistors (T3) das erste Wechselstrom-Referenzpotential (VRef1) zugeführt wird; eine Source-Elektrode und eine Drain-Elektrode des dritten Dünnschichttransistors (T3) jeweils mit dem ersten Wechselstrom-Referenzpotential (VRef1) beaufschlagt und mit dem ersten Knoten (S(N)) verbunden sind; eine Gate-Elektrode des vierten Dünnschichttransistors (T4) mit dem ersten Wechselstrom-Referenzpotential (VRef1) beaufschlagt wird; eine Source-Elektrode und eine Drain-Elektrode des vierten Dünnschichttransistors (T4) jeweils mit dem zweiten Wechselstrom-Referenzpotential (VRef2) beaufschlagt und mit dem zweiten Knoten (T(N)) verbunden sind, und wobei während einer Austastzeitdauer einer Bildperiode das erste Wechselstrom-Referenzpotential (VRef1) und das zweite Wechselstrom-Referenzpotential (VRef2) auf einem hohen Potential liegen, um den dritten Dünnschichttransistor (T3) und den vierten Dünnschichttransistor (T4) auf einem hohen Potential liegen und das Gate-Leitungssignal sowie das Datensignal auf einem niedrigen Potential liegen, und das erste Wechselstrom-Referenzpotential (VRef1) und das zweite Wechselstrom-Referenzpotential (VRef2) auf einem niedrigen Potential liegen, um den dritten Dünnschichttransistor (T3) und den vierten Dünnschichttransistor (T4) während des restlichen Teils der Bildperiode auszuschalten.

2. Externe OLED-Kompensationsschaltung für einen TFT vom Verarmungstyp nach Anspruch 1, **dadurch gekennzeichnet, dass** die Gleichstrom-Hochspannungsversorgung (VDD) ein Potential von 28 V aufweist und das hohe Potential 28 V sowie das niedrige Potential -7 V beträgt.

## Revendications

1. Circuit de compensation externe OLED d'un TFT de type à appauvrissement, comprenant un premier transistor à couche mince (T1), un deuxième transistor à couche mince (T2), un condensateur (Cst), une diode électroluminescente organique (OLED) et un circuit de compensation (30) ; le deuxième transistor à couche mince (T2) étant de type à appauvrissement ; des moyens configurés pour appliquer un signal de ligne de grille (G(N)) à une électrode de grille du premier transistor à couche mince (T1) ; des moyens configurés pour appliquer un signal de données (VData) à une électrode de source du premier transistor à couche mince (T1) ;
une électrode de drain du premier transistor à couche mince (T1) étant reliée à un premier noeud (S(N)) ; une grille du deuxième transistor à couche mince (T2) étant reliée au premier noeud (S(N)) ; des moyens configurés pour fournir une alimentation en courant continu haute tension (VDD) à une électrode de source du deuxième transistor à couche mince (T2) ; une électrode de drain du deuxième transistor à couche mince (T2) étant connectée à un deuxième noeud (T(N)) ; une extrémité du condensateur (Cst) étant reliée au premier noeud (S(N)) et l'autre extrémité du condensateur (Cst) étant reliée au deuxième noeud (T(N)) ; une électrode positive de la diode électroluminescente organique (OLED) étant reliée au deuxième noeud et une électrode négative de la diode électroluminescente organique (OLED) étant mise à la masse ; le circuit de compensation (30) étant connecté au premier noeud (S(N)) et au deuxième noeud (T(N)) ; des moyens configurés pour fournir un premier potentiel de référence alternatif (VRef1) et un deuxième potentiel de référence alternatif (VRef2) au circuit de compensation (30) ;
**caractérisé en ce que** la différence de tension entre le premier potentiel de référence alternatif (VRef1) et le deuxième potentiel de référence alternatif (VRef2) est réglable, le circuit de compensation (30) comprenant un troisième transistor à couche mince (T3) et un quatrième transistor à couche mince (T4) ; une électrode de grille du troisième transistor à couche mince (T3) reçoit le premier potentiel de référence alternatif (VRef1) ; une électrode de source et une électrode de drain du troisième transistor à couche mince (T3) reçoivent respectivement le premier potentiel de référence alternatif (VRef1) et sont reliées au premier noeud (S(N)) ; une électrode de grille du quatrième transistor à couche mince (T4) reçoit le premier potentiel de référence alternatif (VRef1) ; une électrode de source et une électrode de drain du quatrième transistor à couche mince (T4) reçoivent respectivement le deuxième potentiel de référence alternatif (VRef2) et sont connectées au deuxième noeud (T(N)), et dans lequel, pendant une période de suppression d'une période de trame, le premier potentiel de référence alternatif (VRef1) et le deuxième potentiel de référence alternatif (VRef2) sont à un potentiel haut pour activer respectivement le troisième transistor à couche mince (T3) et le quatrième transistor à couche mince (T4), respectivement, et le signal de ligne de grille et le signal de données sont à un potentiel bas, et le premier potentiel de référence alternatif (VRef1) et le deuxième potentiel de référence alternatif (VRef2) sont à un potentiel bas pour désactiver le troisième transistor à couche mince (T3) et le quatrième transistor à couche mince (T4) pendant le reste de la période de trame.

2. Circuit de compensation externe OLED d'un TFT de type à appauvrissement selon la revendication 1, **caractérisé en ce que** l'alimentation haute tension en courant continu (VDD) présente un potentiel de 28 V, le potentiel haut étant de 28 V et le potentiel bas de -7 V.
